# EUROPÄISCHE PATENTSCHRIFT

(11) **EP 1 394 855 B1**
(45) Veröffentlichungstag und Bekanntmachung des Hinweises auf die Patenterteilung: **19.12.2012**
(21) Anmeldenummer: 03016642.5
(22) Anmeldetag: 30.07.2003
(51) Int. Cl.: H01L 23/31, H01L 23/498

(54) **Verfahren zur Herstellung eines universellen Gehäuses für ein elektronisches Bauteil mit Halbleiterchip**
Method of manufacturing a universal housing for an electronic semiconductor device
Procédé de fabrication d'un boîtier universel pour dispositif électronique semi-conducteur

(30) Priorität: 29.08.2002 DE 10240461
(43) Veröffentlichungstag der Anmeldung: 03.03.2004
(73) Patentinhaber: Infineon Technologies AG, 85579 Neubiberg (DE)
(72) Erfinder: Goller, Bernd, 83624 Otterfing (DE); Hagen, Robert-Christian, 93092 Sarching (DE); Ofner, Gerald, 93077 Bad Abbach (DE); Stümpfl, Christian, 92421 Schwandorf (DE); Wein, Stefan, 93138 Lappersdorf (DE); Wörner, Holger, 93049 Regensburg (DE)
(74) Vertreter: Schweiger, Martin

(56) Entgegenhaltungen:
- EP-A- 0 920 058
- US-A1- 2002 110 956
- US-B1- 6 306 685
- PATENT ABSTRACTS OF JAPAN Bd. 2000, Nr. 21, 3. August 2001 (2001-08-03) -& JP 2001 110945 A (MOTOROLA INC), 20. April 2001 (2001-04-20)

## Beschreibung

Die Erfindung betrifft ein Verfahren zur Herstellung eines Nutzen mit mehreren Bauteilpositionen für elektronische Bauteile.

In der Halbleiterfertigung besteht das Bestreben elektronische Bauteile so weit wie möglich preiswert als Nutzen vorzufertigen. Eine derartige Fertigung ist aus der Druckschrift US 6,239,482 bekannt. Dabei werden unterschiedliche Herstellungsschritte gleichzeitig für mehrere elektronische Bauteile durchgeführt, was jedoch zu Kontaktierungs- und Verbindungsproblemen der in einem Nutzen eingebetteten Halbleiterchips und deren Chipkontakte mit den an die Chipkontakte heranzuführenden Umverdrahtungsleitungen oder Durchkontakte führt. Dadurch wird die Ausbeute an funktionsfähigen elektronischen Bauteilen pro Nutzen beeinträchtigt.

Stand der Technik ist in EP-A-0920058 und in US 2002/110956 A beschrieben.

Aufgabe der Erfindung ist es, ein elektronisches Bauteil, sowie einen Nutzen zu schaffen, mit denen die Kontaktierungs- und Verbindungsprobleme vermindert werden. Ferner ist es Aufgabe der Erfindung ein Verfahren zur Herstellung eines derartigen Nutzens und eines derartigen elektronischen Bauteils anzugeben.

Gelöst wird diese Aufgabe mit dem Gegenstand der unabhängigen Ansprüche. Vorteilhafte Weiterbildungen der Erfindung ergeben sich aus den jeweiligen abhängigen Ansprüchen.

Erfindungsgemäß wird ein Herstellung Verfahren für ein elektronisches Bauteil mit einem Halbleiterchip angegeben, der auf seinen Kontaktflächen Chipkontakte aufweist. Diese Chipkontakte sind auf Kontaktanschlussflächen mindestens einer Umverdrahtungsstrukturen mechanisch fixiert und mit der Umverdrahtungsstruktur elektrisch verbunden. Die Umverdrahtungsstruktur ist dabei als Bereich einer strukturierten Metallplatte ausgebildet. Sie kann auch als Bereich einer strukturierten Metallschicht einer metallkaschierten Grundplatte ausgebildet sein.

Die strukturierte Metallplatte kann als Bereich einer Metallplatte ausgebildet sein, der nur noch die Umverdrahtungsstruktur eines elektronischen Bauteils aufweist, während die übrigen Bereiche der Metallplatte entfernt sind. Gleiches gilt für den Bereich einer strukturierten Metallschicht einer metallkaschierten Grundplatte, der die Umverdrahtungsstruktur des elektronischen Bauteils aufweisen kann, während die übrige Metallschicht und die Grundplatte entfernt sind.

Die Erfindung lässt sich anhand des Gefüges der Umverdrahtungsstruktur leicht erkennen. Eine Umverdrahtungsstruktur aus einer strukturierten Metallplatte oder einer strukturierten Metallschicht einer metallkaschierten Grundplatte zeichnet sich nämlich durch die besondere Struktur der darin enthaltenen Metallkristalle aus, die sich beim Walzen sowohl der Metallplatte als auch beim Walzen der kaschierenden Metallschicht einer metallkaschierten Grundplatte ausbildet. Diese als Walztextur erkennbare Struktur der Metallkristalle der Umverdrahtungsstruktur hat den Vorteil, daß auf deren Kontaktanschlussflächen unmittelbar der Halbleiterchip mit seinen Chipkontakten anders als bei galvanisch erzeugten oder aufgedampften oder aufgesputterten Metallschichten sofort und ohne besondere Vorbehandlung kontrolliert mechanisch fixiert ist. Dabei wird unter mechanisch fixiert eine mechanische Fügung der Chipkontakte des Halbleiterchips auf den Kontaktanschlussflächen der Umverdrahtungsstruktur beispielsweise mit einem Fügeverfahren verstanden.

Mit einer derartigen mechanischen Fixierung wird gleichzeitig eine elektrische Verbindung zwischen den Kontaktanschlussflächen der Umverdrahtungsstruktur und den Chipkontakten des Halbleiterchips gewährleistet, so dass die Kontaktierungsund Verbindungsprobleme gemindert sind. Entsprechend wird die Ausbeute an funktionsfähigen elektronischen Bauteilen pro Nutzen erhöht.

Als Chipkontakte kann der Halbleiterchip Lötbälle aufweisen, die auf die Kontaktflächen des Halbleiterchips gelötete Lötkugeln darstellen. Darüber hinaus können Chipkontakte als Löthöcker ausgebildet sein, die auf den Kontaktflächen eines Halbleiterchips durch Drucktechnik mit anschließendem Sinterverfahren hergestellt sind. Die Chipkontakte eines Halbleiterchips können auch als Flächenkontakte ausgebildet sein, wobei die Kontaktflächen der Halbleiterchips beispielsweise durch ein lötbares Material vergrößert und verdickt sind. Auch Kopfkontakte sind als Chipkontakte möglich, die einen Thermokompressionskopf aufweisen und als stud bumps bekannt sind. Darüber hinaus können Chipkontakte als überhöhte Anschlussflächen durch galvanische Abscheidung eines Metalls auf den Kontaktflächen als Säulenkontakte dargestellt sein.

Außerdem wird erfindungsgemäß ein Nutzen mit mehreren Bauteilpositionen für elektronische Bauteile geschaffen. Der Nutzen weist eine selbsttragende formstabile Kunststoffplatte auf, in der in jeder Bauteilposition ein Halbleiterchip eingebettet ist. Jeder der Halbleiterchips weist auf seinen Kontaktflächen Chipkontakte auf. Diese Chipkontakte sind in jeder der Bauteilpositionen auf Kontaktanschlussflächen mindestens einer Umverdrahtungsstruktur mechanisch fixiert und mit der Umverdrahtungsstruktur elektrisch verbunden.

Die Umverdrahtungsstruktur ist als Bereich einer strukturierten Metallplatte oder einer strukturierten Metallschicht einer metallkaschierten Grundplatte ausgebildet. Sowohl der Bereich der strukturierten Metallplatte als auch der Bereich der strukturierten Metallschicht einer metallkaschierten Grundplatte weisen Walztexturen auf, die auf den Einsatz derartiger Metallplatten beziehungsweise Metallschichten hinweisen. Derartige gewalzte und zu Umverdrahtungsstrukturen strukturierte Metallplatten bzw. Metallschichten einer metallkaschierten Grundplatte haben den Vorteil, dass sie vor ihrer Strukturierung als Trägerplatte für einen Nutzen mit mehreren Bauteilpositionen zum Fügen der Chipkontakte des Halbleiterchips in den Bauteilpositionen und zusätzlich als Trägerplatte für das Einbetten der Bauteile in eine Kunststoffplatte dienen können.

Sowohl der Halbleiterchip mit den Chipkontakten als auch die Halbleiterchips eines Nutzens sind in einem einzigen Material vollständig eingebettet, so dass thermische Spannungen zwischen unterschiedlichen Gehäusematerialien in vorteilhafter Weise vermieden werden. Das Material der Kunststoffplatte, in der die Halbleiterchips eingebettet sind, kann eine Kunststoffgehäusemasse aufweisen. Eine derartige Kunststoffgehäusemasse kann insbesondere ein mit elektrisch isolierenden Partikeln gefülltes Epoxidharz aufweisen. Durch das Epoxidharz mit den elektrisch isolierenden Partikeln kann der thermische Ausdehnungskoeffizient der Kunststoffgehäusemasse an den thermischen Ausdehnungskoeffizienten der Halbleiterchips angepasst werden. Somit sind die thermischen Spannungen an der Grenzfläche zwischen Halbleiterchip und Kunststoffgehäusemasse minimiert.

Auf den Grenzflächen zwischen Umverdrahtungsstruktur und Kunststoffplatte kann die Umverdrahtungsstruktur eine Haftschicht aufweisen. Diese Haftschicht sorgt für eine sichere Verankerung der Umverdrahtungsstruktur auf der Kunststoffplatte. Ferner kann die Haftschicht als Muster unter Aussparung der Kontaktanschlussflächen der Umverdrahtungsstruktur auf die nicht strukturierte Metallplatte oder die nicht strukturierte Metallschicht aufgebracht sein. Dadurch erleichtert die Haftschicht zusätzlich ein Ausrichten der Halbleiterchips in den Bauteilpositionen eines Nutzens.

Das elektronische Bauteil oder der Nutzen können weitere Umverdrahtungsstrukturen mit Umverdrahtungsleitungen und/oder Durchkontakten aufweisen. Dabei sind die Durchkontakte mit einer weiteren Umverdrahtungsstruktur und/oder mit Außenkontaktflächen des elektronischen Bauteils oder des Nutzens elektrisch verbunden. Derartige weiterführende Umverdrahtungsstrukturen können mit bekannten Verfahren auf die mindestens ein Umverdrahtungsstruktur der vorliegenden Erfindung aufgebracht sein. Somit kann eine mehrlagige Umverdrahtungsstruktur auf der selbsttragenden formstabilen Kunststoffplatte angeordnet sein, ohne ein separates mehrlagiges Substrat zu benötigen, was die Herstellungskosten vermindert.

Ein Verfahren zur Herstellung eines Nutzens mit mehreren Bauteilpositionen für elektronische Bauteile weist im wesentlichen vier Verfahrensschritte auf. Dabei entsteht ein Nutzen in Form einer selbsttragenden formstabilen Kunststoffplatte, in der in jeder Bauteilposition ein Halbleiterchip eingebettet ist, der auf seinen Kontaktflächen Chipkontakte aufweist.

Zunächst wird für die Herstellung eines Nutzens eine Trägerplatte hergestellt, die eine nicht strukturierte Metallplatte oder eine nicht strukturierte Metallschicht mit Walztextur aufweist. Anschließend werden Halbleiterchips mit ihren Chipkontakten auf dem Metall der Trägerplatte an vorbestimmten Bauteilpositionen ausgerichtet und auf vorbestimmten Bauteilpositionen auf dem Metall der Trägerplatte fixiert. Damit bilden die Trägerplatte und die darauf fixierten Halbleiterchips eine großflächige räumliche Struktur, wobei die Halbleiterchips in Reihen und Spalten angeordnet sein können. Danach wird eine Kunststoffplatte unter Einbetten der Halbleiterchips und ihrer auf dem Metall der Trägerplatte fixierten Chipkontakte in einer Kunststoffmasse auf der Trägerplatte hergestellt. Schließlich wird die zunächst geschlossene Metallplatte oder die geschlossene Metallschicht der Trägerplatte zu einer Umverdrahtungsstruktur strukturiert werden, wobei die Umverdrahtungsstruktur nach diesem Verfahrensschritt Kontaktanschlussflächen, auf denen die Chipkontakte fixiert sind und/oder Umverdrahtungsleitungen und/oder Durchkontakte aufweist.

Dieses Verfahren hat den Vorteil, dass schon vor dem Einbetten der Halbleiterchips in eine Kunststoffmasse die Chipkontakte des Halbleiterchips auf einer Metallplatte oder einer Metallschicht zuverlässig fixiert werden können. Je nach Art der Chipkontakte kann dazu ein Diffusionslöten, ein Kontaktlöten oder ein Kleben zum Fixieren der Chipkontakte auf dem Metall der Trägerplatte eingesetzt werden. Die Metallplatte oder die Teilschicht der Trägerplatte werden nach dem Herstellen der Kunststoffmasse nicht vollständig entfernt, sondern sie werden in vorteilhafter Weise zur Herstellung mindestens einer Umverdrahtungsstruktur eingesetzt. Diese Umverdrahtungsstruktur beispielsweise aus einer Kupferlegierung weist eine kristalline Walztextur auf.

Zur Herstellung einer Trägerplatte kann eine Metallplatte auf eine Dicke zwischen 50 und 150 Mikrometer dünngewalzt werden. Dabei entsteht die für dieses Verfahren charakteristische Walztextur der Metallkristalle. Das Bearbeiten einer derartigen Metallplatte zu einer Umverdrahtungsstruktur lässt aufgrund der Dicke der Metallplatte nur eine begrenzte Feinheit der Umverdrahtungsstruktur zu. Die Feinheit der Umverdrahtungsstruktur lässt sich erhöhen, indem als Trägerplatte eine Grundplatte mit einer Metallschicht hergestellt wird.

Eine derartige Grundplatte kann aus einem Leiterplattenmaterial aufgebaut sein und mit einer gewalzten Metallfolie über eine haftvermittelnde Zwischenschicht kaschiert werden. Nach dem Herstellen einer derartigen Grundplatte mit Metallschicht als Trägerplatte wird zur Strukturierung der Metallschicht zu einer Umverdrahtungsstruktur die Grundplatte von der Metallschicht getrennt. Um eine Trennung zu ermöglichen, werden die haftvermittelnden Eigenschaften der Zwischenschicht zwischen Grundplatte und Metallschicht derart angepasst, dass die Haftungseigenschaften der Metallschicht bezüglich der herzustellenden Kunststoffplatte wesentlich größer ist als zu dem Leiterplattenmaterial.

Zur Herstellung einer Grundplatte mit Metallschicht als Trägerplatte eines Nutzens kann auch eine weiche, nachgiebige Grundplatte aus elastomerem Kunststoff mit einer gewalzten Metallfolien über eine haftvermittelnde Zwischenschicht kaschiert werden. Auch hier werden die Eigenschaften der haftvermittelnden Zwischenschicht derart eingestellt, dass die Haftung zu der flexiblen Grundplatte geringer ist als die Haftung der Metallfolie an der herzustellenden Kunststoffplatte.

Aufgrund der weichen nachgiebigen Grundplatte aus elastomerem Kunststoff kann diese Grundplatte von der herzustellenden Kunststoffplatte mit eingebetteten Halbleiterchips unter Zurücklassen der Metallschicht abgezogen werden, bevor eine Strukturierung der Metallschicht zu einer Umverdrahtungsstruktur durchgeführt wird. Ein weiterer Vorteil einer weichen nachgiebigen Grundplatte aus elastomerem Kunststoff mit aufgebrachter gewalzter Metallfolie ist darin zu sehen, dass die Halbleiterchips mit ihren Chipkontakten in die Metallfolie nach einem Ausrichten eingerückt werden können, so dass sich die Position der Chipkontakte auf der Rückseite der Metallschicht abbildet und ein Einbringen einer Umverdrahtungsstruktur von der Rückseite der Metallschicht aus erleichtert.

Bei der Herstellung der Trägerplatte können auf dem Metall der Trägerplatte Justagemarken vorgesehen werden, um das Ausrichten der Halbleiterchips in den Bauteilpositionen zu erleichtern. Derartige Justagemarken können durch Aufbringen von lötbarem Material in den Positionen der Kontaktanschlussflächen vorgesehen werden. Zusätzlich können Justagemarken beidseitig auf dem Metall der Trägerplatte vorgesehen werden, um einerseits die Halbleiterchips mit ihren Chipkontakten in jeder Bauteilposition auf der einen Seite von der Metallplatte oder der Metallschicht auszurichten und andererseits diese Positionen bei der Strukturierung der Metallplatte oder der Metallschicht von der gegenüberliegenden Seite aus wiederzuerkennen. Als mögliche beidseitige Justagemarken sind Durchgangsöffnungen in dem Metall der Trägerplatte geeignet, die an entsprechenden Positionen in das Metall der Trägerplatte eingebracht werden. Justagemarken können auch als Dellen in der Metallschicht ausgebildet werden, besonders wenn die Grundplatte aus weichem nachgiebigem Material Hergestellt ist. Die Dellen werden dann durch entsprechende Chipkontakte wie Lötbälle, Löthöcker, Kopfkontakte oder Säulenkontakte der Halbleiterchips erzeugt, wenn der Halbleiterchips auf die Metallschicht aufgesetzt wird.

Wenn die Chipkontakte in Form von Flächenkontakten oder überhöhten Anschlussflächen auf den Kontaktflächen der Halbleiterchips ausgebildet sind, so ist ein derartiger Abdruck der Kontaktflächen des Halbleiterchips nicht ohne weiteres möglicht, so dass besonders vorbereitete beidseitige Justagemarken vorzusehen sind. Der Vorteil von Flächenkontakten als Chipkontakte liegt auch darin, dass durch Diffusionslöten der Flächenkontakte auf der Metallschicht beziehungsweise auf der Metallplatte eine mechanisch sehr stabile Verbindung zwischen dem Metall der Trägerplatte und den Flächenkontakten hergestellt werden kann.

Weisen die Halbleiterchips Chipkontakte in Form von Lötbällen, Löthöckern und/oder Kopfkontakten auf, so können diese mittels Weichlöten nach einem Ausrichten der Halbleiterchips auf dem Metall der Trägerplatte fixiert werden. Mittels Weichlöten wird ebenfalls eine sehr stabile Fixierung der Halbleiterchips über ihre Chipkontakte auf dem Metall der Trägerplatte sichergestellt.

Die derartig auf dem Metall der Trägerplatte fixierten Halbleiterchips ermöglichen mit weiteren Verfahrensschritten die Herstellung einer Kunststoffplatte mittels Spritzgusstechnik, da die Fixierung der Chipkontakte äußerst gemäß der Erfindung stabil und sicher ist. Beim Spritzgießen werden die Halbleiterchips innerhalb einer Spritzgussform in eine Kunststoffmasse eingebettet, wobei unter hohem Druck die Spritzgussform mit Kunststoffmasse verfüllt wird. Bei diesem Vorgang, der auch als "Transfermolden" bekannt ist, besteht keine Gefahr, dass sich Kunststoffmasse zwischen das Metall der Trägerplatte und die fixierten Chipkontakte drängt, da vorher eine besonders sichere mechanische Verbindung zwischen dem Metall der Trägerplatte und den Chipkontakten hergestellt wurde.

Zur Verbesserung der Verankerung zwischen der Kunststoffmasse und dem Metall der Trägerplatte kann der Bereich der Umverdrahtungsstruktur des Metalls der Trägerplatte mit einer Haftschicht versehen sein. Diese Haftschicht kann ein Justagemuster bilden, das noch vor dem Bestücken des Metalls der Trägerplatte mit Halbleiterchips auf das Metall aufgebracht wird. Dabei werden die Kontaktanschlussflächen des Umverdrahtungsmusters von Haftschicht freigehalten, um eine sichere Verbindung zwischen den Chipkontakten des Halbleiterchips und dem Metall der Trägerplatte zu gewährleisten.

Zum Herstellen einer Kunststoffplatte kann die Trägerplatte mit darauf fixierten Halbleiterchips auch mit einem Kunststoffgranulat bedeckt werden. Dieses Kunststoffgranulat wird vorzugsweise unter Vakuum aufgeschmolzen und verteilt sich unter Einbetten der Halbleiterchips auf der Trägerplatte. Um das Einebenen des Kunststoffgranulats zu verbessern, kann eine Formplatte planparallel zu der Trägerplatte auf die geschmolzene Kunststoffmasse aufgebracht werden. Damit wird die Oberseite der Kunststoffplatte in vorteilhafter Weise eingeebnet. Durch das Anlegen von Vakuum während des Aufschmelzens werden Lufteinschlüsse in der Kunststoffplatte verhindert.

Eine weitere Möglichkeit, eine Kunststoffplatte mit Hilfe der Trägerplatte herzustellen, besteht darin, die Halbleiterchips mit dispensiertem Kunststoff zu bedecken. Bei diesem Verfahren wird Kunststoff flüssig auf die Trägerplatte aufgetragen, der sich gleichmäßig verteilt und die Halbleiterchips einbettet.

Nach dem Herstellen einer selbsttragenden, formstabilen Kunststoffplatte kann die Metallplatte oder Metallschicht der Trägerplatte strukturiert werden. Dazu wird, falls eine Grundplatte aus Nichtmetallen eingesetzt wurde, diese Grundplatte von der Metallschicht abgezogen und anschließend die Metallschicht selektiv geätzt, wobei eine Ätzmaske die Struktur der Umverdrahtungsstruktur schützt. Neben einem Nassätzen kann auch ein Trockenätzen durchgeführt werden, wozu die Metallschicht oder die Metallplatte einem Plasmaätzverfahren ausgesetzt wird.

Weitere Möglichkeiten präzise Strukturen in die Metallplatte beziehungsweise die Metallschicht einzubringen, bestehen darin, durch Laserabtrag die geschlossene Metallplatte beziehungsweise die Metallschicht zu strukturieren. Auf diese Umverdrahtungsstruktur können weitere Umverdrahtungsstrukturen angeordnet werden, indem im Wechsel Isolationslagen mit Durchkontakten und Isolationslagen mit Umverdrahtungsleitungen auf der mindestens einen Umverdrahtungsstruktur angeordnet werden. Diese weiteren Umverdrahtungsstrukturen können mit herkömmlichen Verfahren realisiert werden, so dass ein Nutzen hergestellt wird, der eine mehrlagige Umverdrahtungsstruktur aufweist. Abschließend können Außenkontakte auf einer äußeren Umverdrahtungsstruktur des Nutzens aufgebracht werden, bevor der Nutzen durch Trennen des Nutzens entlang den Grenzen jeder Bauteilposition zu einzelnen elektronischen Bauteilen aufgeteilt wird.

Zusammenfassend ist festzustellen, dass die Erfindung auf der Verwendung einer Trägerplatte basiert, die sowohl zur Fixierung und Positionierung der Halbleiterchips während der Herstellung eines sogenannten "expandierten" Wafers dient, als auch später zur Herstellung der ersten Umverdrahtungslage eines Gehäuses dient. Ein derartiger "expandierter" Wafer beziehungsweise Nutzen hat den Vorteil, dass die Herstellungsschritte für ein elektronisches Bauteil gemäß der vorliegenden Erfindung parallel für mehrere Bauteile gleichzeitig durchgeführt werden können. Die Halbleiterchips können dazu zunächst mit überhöhten Kontaktstrukturen versehen werden. Dazu sind alle Chipkontakte wie oben aufgeführt geeignet. Dann werden die Halbleiterchips mit ihren Chipkontakten auf einen vollflächigen unstrukturierten metallischen Träger aufgebracht und kontaktiert durch Weichlöten, Diffusionslöten und/oder Legieren. Für die Trägerplatte wird dazu ein leitendes gewalztes Metallmaterial verwendet, das sich sowohl für die Kontaktierung der Halbleiterchips als auch als Material für die Leiterbahnen einer ersten Umverdrahtungslage eignet.

Geeignete Materialien sind Kupfer und Kupferlegierung. Nach dem die Chipkontakte der Halbleiterchips auf der Trägerplatte fixiert sind kann dieser Aufbau vergossen werden, wobei Dispensverfahren oder auch Transfermoldverfahren zum Einsatz kommen können. Anschließend kann der metallische Träger photolithographisch bearbeitet werden und dabei kann die Struktur der ersten Umverdrahtungslage aus der vollflächigen unstrukturierten metallischen Trägerplatte herausgeätzt werden. Auf diese erste Umverdrahtungslage können weitere Schichten mit Umverdrahtungsleitungen mittels herkömmlicher Verfahren, wie einer Dünnfilmtechnik, aufgebracht werden. Die Vorteile des erfindungsgemäßen Verfahrens zur Herstellung eines elektronischen Bauteils beziehungsweise eines Nutzens für mehrere elektronische Bauteile liegen in folgendem:

Es ist kein separater Träger für die Montage notwendig, der wieder verworfen werden muss. Die Verwendung eines im weiteren Verfahren verwendbaren Trägers erspart Kosten.

Mit dieser Technologie lässt sich ein Aufbau verwirklichen, bei dem der Halbleiterchip vollständig sowohl oberhalb als auch unterhalb des Halbleiterchips von demselben Material umgeben ist. Der Vorteil liegt in einer höheren Zuverlässigkeit, da der Halbleiterchip rundum mechanisch fixiert ist und die Delaminationswahrscheinlichkeit an den Halbleiterchipflanken vermindert ist.

Durch die vollständige Einbettung des Halbleiterchips auch oberhalb der aktiven Chipfläche wird die Zuverlässigkeit des Aufbaus weiterhin erhöht, da die Umverdrahtungslagen auf einer einheitlichen Grundfläche aufgebracht werden können. Somit müssen die weiteren Umverdrahtungs- und Isolationslagen in Bezug auf ihre Haftung nicht zusätzlich an das Material des Halbleiterchips angepasst werden.

Da die Kontaktierung der Chipkontakte auf dem Metall der Trägerplatte nicht mittels Abscheide- oder Auftragsprozessen sondern mittels zuverlässigen Fügeverfahren erzielt wird, ergibt sich insgesamt eine höhere Zuverlässigkeit für den Aufbau des elektronischen Bauteils. Das Risiko einer Delamination zwischen der ersten Umverdrahtungslage aus einer gewalzten Metallplatte oder einer gewalzten Metallschicht und dem Halbleiterchip sowie der Gehäuseoberseite ist bei dem erfindungsgemäßen Verfahren vermindert.

Insgesamt wird der Verfahrensablauf wesentlich vereinfacht, da der Bestückungsprozess und der Vergussprozess mit eingeführten Technologien erzielt werden können. Insbesondere werden Schleifprozesse zur Freilegung von Chipkontakten in einer Kunststoffmasse vermieden.

Das Verfahren vermeidet kritische Ablichtungsprobleme und die Gefahr des Verunreinigens zwischen Chipkontakten und erster Umverdrahtungslage.

Die Erfindung wird nun mit Bezug auf die beiliegenden Figuren näher erläutert.
- Figur 1: zeigt einen schematischen Querschnitt durch ein elektronisches Bauteil gemäß einer ersten Ausführungsform der Erfindung,
- Figur 2: zeigt einen schematischen Querschnitt durch ein elektronisches Bauteil gemäß einer zweiten Ausführungsform der Erfindung,
- Figuren 3 bis 6: zeigen schematisch Querschnitte durch Zwischenprodukte im Rahmen der Herstellung eines erfindungsgemäßen Nutzens für mehrere elektronische Bauteile,

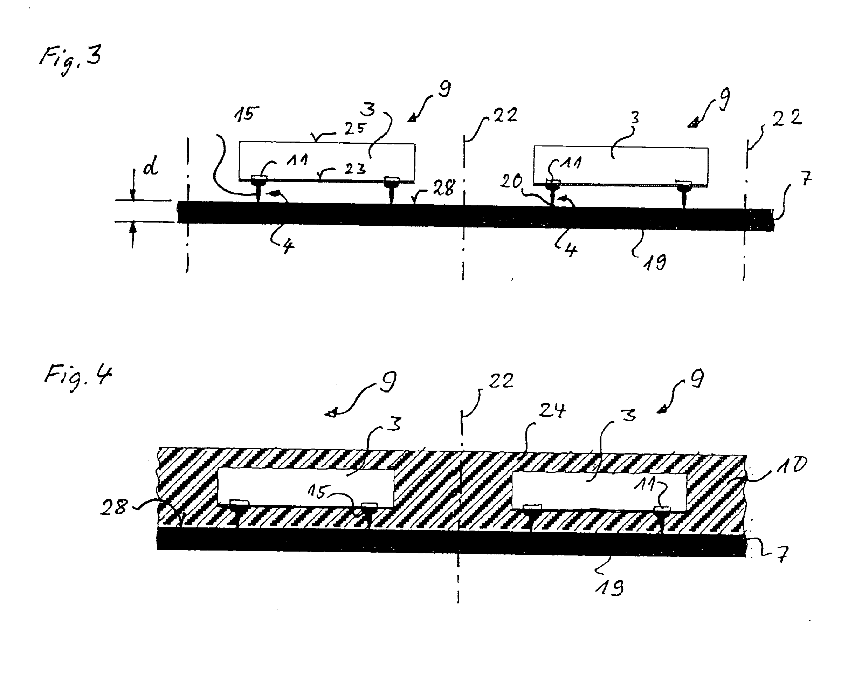

- Figur 3: zeigt einen schematischen Querschnitt durch Halbleiterchips nach einem Ausrichten und Fixieren von deren Chipkontakten auf einer metallischen Trägerplatte,
- Figur 4: zeigt einen schematischen Querschnitt durch eine Kunststoffplatte mit dem darin eingebetteten Halbleiterchips auf der metallischen Trägerplatte aus Figur 3,

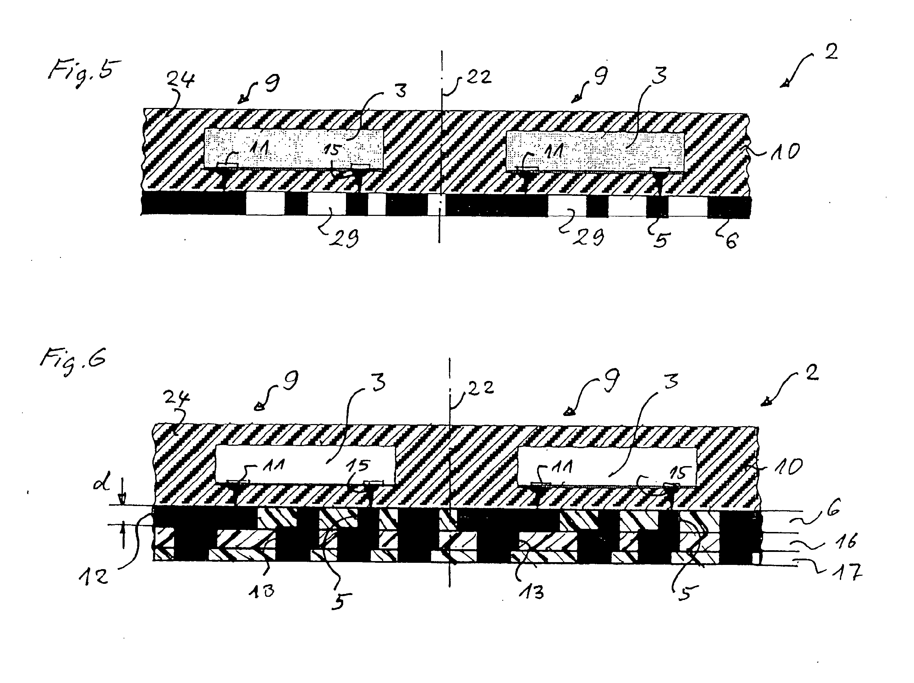

- Figur 5: zeigt einen schematischen Querschnitt durch einen Nutzen nach dem Strukturieren der metallischen Trägerplatte aus den Figuren 3 und 4 zu einer Umverdrahtungsstruktur,
- Figur 6: zeigt einen schematschen Querschnitt durch den Nutzen aus Fig. 5 nach dem Aufbringen von weiteren Umverdrahtungslagen..

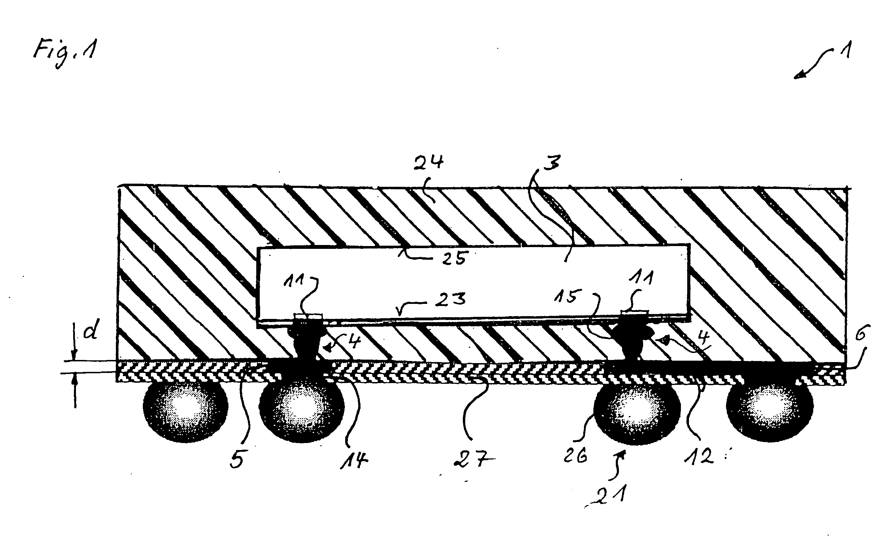

Figur 1 zeigt einen schematischen Querschnitt durch ein elektronisches Bauteil 1 gemäß einer ersten Ausführungsform der Erfindung. Das elektronische Bauteil 1 weist einen Halbleiterchip 3 mit einer aktiven Oberseite 23 und einer passiven Rückseite 25 auf. Auf der aktiven Oberseite 23 sind Kontaktflächen 11 angeordnet, die Chipkontakte 4 tragen. In dieser ersten Ausführungsform der Erfindung sind die Chipkontakte 4 als Kopfkontakte 15 bzw. stud bumps ausgebildet. Die Kopfkontakte 15 sind auf Kontaktanschlussflächen 5 einer Umverdrahtungsstruktur 6 fixiert. Die Umverdrahtungsstruktur 6 ist aus einem Bereich einer strukturierten Metallplatte oder mit einem hier nicht veranschaulichten Verfahren aus einem Bereich einer strukturierten Metallschicht gebildet. Die strukturierte Metallplatte oder die strukturierte Metallschicht sind aus einer gewalzten Kupferlegierung hergestellt und weisen eine Walztextur auf. Diese Walztextur ist auch auf der Umverdrahtungsstruktur 6 nachweisbar. Solange die Umverdrahtungsstruktur nicht bedeckt ist, ist die Walztextur häufig mit bloßem Auge erkennbar.

Die Umverdrahtungsstruktur 6 weist neben den Kontaktanschlussflächen 5, auf denen die Kopfkontakte 15 fixiert sind, auch Umverdrahtungsleitungen 12 auf, welche die Kontaktanschlussflächen 5 mit Außenkontaktflächen 14 des elektronischen Bauteils 1 verbinden. Die Dicke d der Umverdrahtungsstruktur 6 liegt zwischen 50 und 150 µm. Die Außenkontaktflächen 14 sind von einer Lötstopplackschicht 27 umgeben und tragen Außenkontakte 21, die in dieser Ausführungsform der Erfindung als Lötbälle 26 ausgebildet sind. Die Lötstopplackschicht 27 verhindert, dass das Lötmaterial der Lötbälle 26 die Umverdrahtungsleitungen 12 beim Verlöten der Lötbälle 26 benetzt. Der Halbleiterchip 3 ist mit seinen Chipkontakten 4 vollständig in einer einzigen Kunststoffmasse 24 eingebettet.

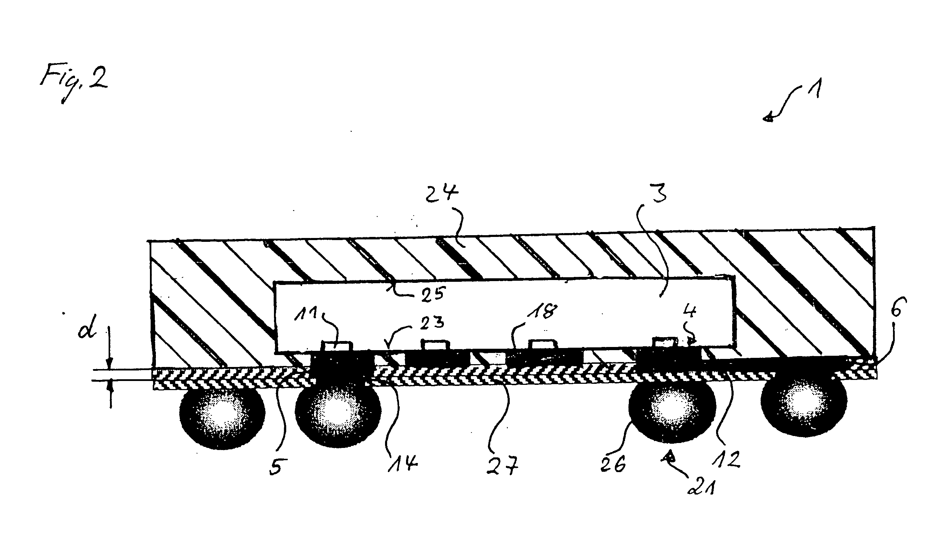

Figur 2 zeigt einen schematischen Querschnitt durch ein elektronisches Bauteil 1 gemäß einer zweiten Ausführungsform der Erfindung. Komponenten mit gleichen Funktionen wie in Figur 1 werden mit gleichen Bezugszeichen gekennzeichnet und nicht extra erörtert.

Die zweite Ausführungsform der Erfindung nach Figur 2 unterscheidet sich von der ersten Ausführungsform der Erfindung durch die Art der Chipkontakte 4 auf den Kontaktflächen 11 auf der aktiven Oberseite 23 des Halbleiterchips 3. Diese Chipkontakte 4 sind als Flächenkontakte 18 ausgebildet und weisen eine mit dem Material der Kontaktanschlussflächen 14 der Umverdrahtungsstruktur 6 diffusionslötbare Legierung auf. Ferner ist die Dicke d des Metalls der Umverdrahtungsstruktur auf die Dicke einer Metallschicht zwischen 0,5 und 50 µm reduziert.

Die Figuren 3 bis 6 zeigen schematische Querschnitte durch Zwischenprodukte im Rahmen der Herstellung eines erfindungsgemäßen Nutzens 2 für mehrere elektronische Bauteile, Komponenten der Figuren 3 bis 6 mit Funktionen wie in den vorhergehenden Figuren werden mit gleichen Bezugszeichen gekennzeichnet und nicht extra erörtert.

Figur 3 zeigt einen schematischen Querschnitt durch Halbleiterchips 3 nach einem Ausrichten und Fixieren von deren Chipkontakte 4 auf einer metallischen Trägerplatte 19. Die metallische Trägerplatte 19 weist Bauteilpositionen 9 auf, deren Grenzen durch strichpunktierte Linien 22 in Figur 3 gezeigt werden. Die Trägerplatte 19 weist eine Kupferlegierung auf, die auf eine Dicke d gewalzt wurde, so dass die metallische Trägerplatte 19 eine walztextur zeigt.

In einer hier nicht gezeigten Ausführungsform ist die Dicke d auf die Dicke einer Metallschicht einer nicht gezeigten metallkaschierten Grundplatte reduziert, wobei die Dicke d der Metallschicht zwischen 0,5 µm und 50 µm liegt. Die nicht gezeigte Grundplatte ist entweder eine Leiterplatte oder eine weiche elastische Folie aus elastomerem Kunststoff.

Auf dem metallischen Träger 19 sind die Chipkontakte 4 an Fixierpunkten 20 aufgelötet. Die Oberseite 28 der metallischen Trägerplatte 19 ist bis auf die Fixierpunkte 20 mit einer auf der metallischen Trägerplatte 19 ermöglicht. Nach dem Fixieren der Chipkontakte 4 mittels Weichlöten in den Fixierpunkten 20 können die Halbleiterchips 3 in eine Kunststoffmasse eingebettet werden.

Figur 4 zeigt einen schematischen Querschnitt durch eine Kunststoffplatte 10 mit den darin eingebetteten Halbleiterchips 3 auf der metallischen Trägerplatte 19 aus Figur 3. Eine Kunststoffmasse'24 aus gefülltem Epoxidharz umgibt nach dem Herstellen der Kunststoffplatte 10 vollständig die Halbleiterchips 3 mit ihren Chipkontakten 4. Dazu wird die metallische Trägerplatte 19 auf ihrer Oberseite 28 einseitig mit Kunststoffmasse 24 beschichtet.

Figur 5 zeigt einen schematischen Querschnitt durch einen Nutzen 2 nach Strukturieren der metallischen Trägerplatte 19 der Figuren 3 und 4 in eine Umverdrahtungsstruktur 6. Zur Strukturierung der in den Figuren 3 und 4 gezeigten geschlossenen metallischen Trägerplatte 19 zu einer Umverdrahtungsstruktur 6 wird eine Photolackmaske auf die metallische Trägerplatte aufgebracht. Anschließend werden die nicht von einer Photolackmaske bedeckten Bereiche 29 herausgeätzt, so dass von der metallischen Trägerplatte eine Umverdrahtungsstruktur 6 übrigbleibt. Diese Umverdrahtungsstruktur 6 weist die gleiche kristalline Struktur wie die in den Figuren 3 und 4 gezeigte metallische Trägerplatte 19 auf und ist somit durch eine Walztextur gekennzeichnet.

Figur 6 zeigt einen schematischen Querschnitt durch einen Nutzen 2 nach Aufbringen von weiteren Umverdrahtungslagen 16 und 17 auf die Umverdrahtungsstruktur 6 der Figur 5. Diese weiteren Umverdrahtungslagen 16 und 17 sind mit herkömmlichen Drucktechniken aufgebracht, um eine mehrlagige Umverdrahtungsstruktur zu realisieren. Anschließend werden auf den Nutzen 2 hier nicht gezeigte weitere Isolationslagen aufgebracht, die Durchkontakte und/oder Außenkontaktflächen aufweisen, auf denen hier nicht gezeigte Außenkontakte aufgebracht sind.

## Patentansprüche

1. Verfahren zur Herstellung eines Nutzens (2) mit mehreren Bauteilpositionen (9) für elektronische Bauteile (1), wobei der Nutzen (2) eine selbsttragende formstabile Kunststoffplatte (10) aufweist, in der in jeder Bauteilposition (9) ein Halbleiterchip (3) eingebettet ist, der auf seinen Kontaktflächen (11) Chipkontakte (4) aufweist, und wobei das Verfahren folgende Verfahrensschritte aufweist:
a) Herstellen einer Trägerplatte (19), die eine nicht strukturierte Metallschicht (8) aufweist, wobei zur Herstellung der Trägerplatte (19) mit Metallschicht (8) eine Grundplatte aus Leiterplattenmaterial mit einer gewalzten Metallfolie über eine haftvermittelnde Zwischenschicht kaschiert wird,
b) Ausrichten und Fixieren von Chipkontakten eines Halbleiterchips (3) auf eine vorbestimmte beziehungsweise auf einer vorbestimmten Bauteilposition (9) des Metalls der Trägerplatte (19),
c) Herstellen einer Kunststoffplatte (10) unter Einbetten der Halbleiterchips (3) und ihrer auf dem Metall der Trägerplatte fixierten Chipkontakte (4) in eine Kunststoffmasse auf der Trägerplatte (19),
d) Strukturieren der Metallplatte (7) oder der Metallschicht (8) der Trägerplatte (19) zu einer Umverdrahtungsstruktur (6) mit Kontaktanschlussflächen (5), auf denen die Chipkontakte (4) fixiert sind, und/oder mit Umverdrahtungsleitungen (12) und/oder mit Durchkontakten (13).

2. Verfahren nach Anspruch 1,
**dadurch gekennzeichnet, dass**
zur Herstellung der Trägerplatte (19) mit Metallschicht (8) eine weiche, nachgiebige Grundplatte aus elastomerem Kunststoff mit einer gewalzten Metallfolie über eine haftvermittelnden Zwischenschicht kaschiert wird.

3. Verfahren nach einem der Ansprüche 1 oder 2,
**dadurch gekennzeichnet, dass** bei der Herstellung der Trägerplatte (19) auf dem Metall der Trägerplatte (19) Justagemarken vorgesehen werden.

4. Verfahren nach einem der Ansprüche 1 bis 3,
**dadurch gekennzeichnet, dass** als Justagemarken Durchgangsöffnungen in das Metall der Trägerplatte (19) eingebracht werden.

5. Verfahren nach einem der Ansprüche 1 bis 3,
**dadurch gekennzeichnet, dass** Dellen als Justagemarken in die Metallschicht (8) der Trägerplatte (19) an den Fixierpunkten (20) der Chipkontakte (4) eingebracht werden.

6. Verfahren nach einem der Ansprüche 1 bis 5,
**dadurch gekennzeichnet, dass** Chipkontakte (4) in Form von Flächenkontakten (18) auf dem Metall der Trägerplatte (19) durch Diffusionslöten mechanisch fixiert werden.

7. Verfahren nach einem der Ansprüche 1 bis 5,
**dadurch gekennzeichnet, dass** Chipkontakte (4) in Form von Lötbällen, Löthöckern, und/oder Kopfkontakten (15) mittels Weichlöten nach einem Ausrichten des Halbleiterchips (3) auf dem Metall der Trägerplatte (19) fixiert werden.

8. Verfahren nach einem der Ansprüche 1 bis 7,
**dadurch gekennzeichnet, dass** zum Herstellen einer Kunststoffplatte (10) die Trägerplatte (19) mit fixierten Halbleiterchips (3) in eine Spritzgussform eingebracht wird, und die Spritzgussform mit einer Kunststoffmasse unter Einbetten der Halbleiterchips (3) verfüllt wird.

9. Verfahren nach einem der Ansprüche 1 bis 7,
**dadurch gekennzeichnet, dass** zum Herstellen einer Kunststoffplatte (10) die Trägerplatte (19) mit fixierten Halbleiterchips (3) mit Kunststoffgranulat bedeckt wird und die Trägerplatte (19) unter Aufschmelzen des Granulats erwärmt wird, wobei eine Formplatte planparallel zu der Trägerplatte (19) auf die geschmolzene Kunststoffmasse aufgebracht wird.

10. Verfahren nach einem der Ansprüche 1 bis 7,
**dadurch gekennzeichnet, dass** zum Herstellen einer Kunststoffplatte (10) die Trägerplatte (19) mit fixierten Halbleiterchips (3) mit dispensiertem Kunststoff unter Einbetten der Halbleiterchips (3) bedeckt wird.

11. Verfahren nach einem der Ansprüche 1 bis 10,
**dadurch gekennzeichnet, dass** das Strukturieren des Metalls der Trägerplatte (19) auf der Kunststoffplatte (10) zu einer Umverdrahtungsstruktur (6) mit Kontaktanschlussflächen (5), auf denen die Chipkontakte (4) fixiert sind, und/oder mit Umverdrahtungsleitungen (12) und/oder mit Durchkontakten (13) durch Nassätzen des Metalls nach Ausrichten und Aufbringen einer Ätzmaske erfolgt.

12. Verfahren nach einem der Ansprüche 1 bis 11,
**dadurch gekennzeichnet, dass** vor einem Strukturieren der Metallschicht (8) der Trägerplatte (19) die Grundplatte von der Metallschicht (8) entfernt wird.

13. Verfahren nach einem der Ansprüche 1 bis 12,
**dadurch gekennzeichnet, dass** weitere Umverdrahtungsstrukturen (6) auf der Kunststoffplatte (10) angeordnet werden, indem im Wechsel Isolationslagen mit Durchkontakten (13) und Isolationslagen mit Umverdrahtungsleitungen (12) auf der mindestens einen Umverdrahtungsstruktur (6) angeordnet werden.

14. Verfahren nach einem der Ansprüche 1 bis 13,
**dadurch gekennzeichnet, dass** Außenkontakte (21) auf eine äußere Umverdrahtungsstruktur (6, 16, 17) des Nutzens (2) aufgebracht werden.

15. Verfahren zur Herstellung eines elektronischen Bauteils (1) aus einer Bauteilposition (9) eines Nutzens (2) mit den Schritten: Herstellen eines Nutzens gemäß einem der Verfahrensansprüche 1 bis 14 und Trennen des Nutzens (2) entlang der Grenzen (22) jeder der Bauteilpositionen (9) des Nutzens (2).

## Claims

1. Method for producing a panel (2) with a number of component positions (9) for electronic components (1), the panel (2) having a self-supporting dimensionally stable sheet of plastic (10), in which a semiconductor chip (3) is embedded in each component position (9) and has chip contacts (4) on its contact areas (11), and the method having the following method steps:
a) producing a support plate (19), which has a non-structured metal layer (8), wherein, to produce the support plate (19) with a metal layer (B), a base plate of printed circuit board material is clad with a rolled metal foil by means of a coupling intermediate layer,
b) aligning chip contacts of a semiconductor chip (3) at a predetermined component position (9) of the metal of the support plate (9) and fixing them on said position,
c) producing a sheet of plastic (10), with the semiconductor chips (3) and their chip contacts (4), which are fixed on the metal of the support plate, being embedded in a plastic molding compound on the support plate (19),
d) structuring the metal plate (7) or the metal layer (8) of the support plate (19) to form a wiring structure (6) with contact terminal areas (5), on which the chip contacts (4) are fixed, and/or with wiring lines (12) and/or with contact vias (13).

2. Method according to Claim 1, **characterized in that**, to produce a base plate (19) with a metal layer (8), a soft, compliant base plate of elastomeric plastic is clad with a rolled metal foil by means of a coupling intermediate layer.

3. Method according to either of Claims 1 and 2, **characterized in that**, in the production of the support plate (19), adjusting marks are provided on the metal of the support plate (19).

4. Method according to one of Claims 1 to 3, **characterized in that** through-openings are made into the metal of the support plate (19) as adjusting marks.

5. Method according to one of Claims 1 to 3, **characterized in that** dents are made into the metal layer (8) of the support plate (19) at the fixing points (20) of the chip contacts (4) as adjusting marks.

6. Method according to one of Claims 1 to 5, **characterized in that** chip contacts (4) in the form of area contacts (18) are mechanically fixed on the metal of the support plate (19) by diffusion soldering.

7. Method according to one of Claims 1 to 5, **characterized in that** chip contacts (4) in the form of solder balls, solder bumps and/or head contacts (15) are fixed on the metal of the support plate (19) by means of soft soldering after alignment of the semiconductor chip (3).

8. The method according to one of Claims 1 to 7, **characterized in that**, to produce a sheet of plastic (10), the support plate (19) with fixed semiconductor chips (3) is introduced into the injection mold, and the injection mold is filled with a plastic molding compound, with the semiconductor chips (3) being embedded.

9. Method according to one of Claims 1 to 7, **characterized in that**, to produce a sheet of plastic (10), the support plate (19) with fixed semiconductor chips (3) is covered with granules of plastic and the support plate (19) is heated, with the granules been melted, a mold plate being applied to the molten plastic molding compound plane-parallel to the support plate (19).

10. Method according to one of Claims 1 to 7, **characterized in that**, to produce a sheet of plastic (10), the support plate (19) with fixed semiconductor chips (3) is covered with dispensed plastic, with the semiconductor chips (3) being embedded.

11. Method according to one of Claims 1 to 10, **characterized in that** the structuring of the metal of the support plate (19) on the sheet of plastic (10) to form a wiring structure (6) with contact terminal areas (5), on which the chip contacts (4) are fixed, and/or with wiring lines (12) and/or with contact vias (13) is performed by wet etching of the metal after aligning and applying an etching mask.

12. Method according to one of Claims 1 to 11, **characterized in that**, before structuring of the metal layer (8) of the support plate (19), the base plate is removed from the metal layer (8).

13. Method according to one of Claims 1 to 12, **characterized in that** further wiring structures (6) are arranged on the sheet of plastic (10), **in that** insulating layers with contact vias (13) and insulating layers with wiring lines (12) are alternately arranged on the at least one wiring structure (6).

14. Method according to one of Claims 1 to 13, **characterized in that** external contacts (21) are applied to an outer wiring structure (6, 16, 17) of the panel (2).

15. Method for producing an electronic component (1) from a component position (9) of a panel (2), having the steps of: producing a panel according to one of the method Claims 1 to 14 and separating the panel (2) along the limits (22) of each of the component positions (9) of the panel (2).

## Revendications

1. Procédé de fabrication d'un ancillaire (2) ayant plusieurs positions (9) pour des composants (1) électroniques, l'ancillaire (2) ayant une plaque (10) en matière plastique autoportante et de forme stable, dans laquelle en chaque position (9) de composant est incorporée une puce (3) à semiconducteur, qui a sur ses faces (11) de contact des contacts (4) de puce et dans lequel le procédé a des stades de procédé suivants :
a) on fabrique une plaque (19) de support, qui a une couche (8) métallique non structurée, une plaque de base en un matériau de plaquette à circuit imprimé étant laminée avec un feuillard métallique laminé sur une couche intermédiaire adhésive pour la fabrication de la plaque (19) de support ayant une couche (8) métallique,
b) on oriente et on immobilise des contacts d'une puce (3) à semiconducteur sur une position (9) de composant déterminée à l'avance du métal de la plaque (19) de support,
c) on fabrique une plaque (10) en matière plastique en incorporant les puces (13) à semiconducteur et leurs contacts (4) de puce immobilisés sur le métal de la plaque de support dans une masse de matière plastique sur la plaque (19) de support,
d) on structure la plaque (7) métallique ou la couche (8) métallique de la plaque (19) de support en une structure (6) de recâblage ayant des faces (5) formant bornes de contact, sur lesquelles les contacts (4) de puce sont immobilisés, et/ou ayant des lignes (12) de recâblage et/ou des contacts (13) traversants.

2. Procédé suivant la revendication 1,
**caractérisé en ce que**
pour la fabrication de la plaque (19) de support ayant une couche (8) métallique, on lamine une plaque de base molle souple en une matière plastique élastomère avec un feuillard métallique laminé sur une couche intermédiaire adhésive.

3. Procédé suivant la revendication 1 ou 2,
**caractérisé en ce que**
dans la fabrication de la plaque (19) de support, on prévoit des repères d'ajustement sur le métal de plaque (19) de support.

4. Procédé suivant l'une des revendications 1 à 3, **caractérisé en ce que**
on introduit comme repères d'ajustement des ouvertures traversantes dans le métal de la plaque (19) de support.

5. Procédé suivant l'une des revendications 1 à 3, **caractérisé en ce que**
on introduit des bosses comme repères d'ajustement dans la couche (8) métallique de la plaque (19) de support aux points (20) d'immobilisation des contacts (4) de puce.

6. Procédé suivant l'une des revendications 1 à 5, **caractérisé en ce que**
on immobilise mécaniquement par brasure, par diffusion des contacts (4) de puce sous la forme de contacts (18) de surface sur le métal de la plaque (19) de support.

7. Procédé suivant l'une des revendications 1 à 5, **caractérisé en ce que**
on immobilise sur le métal de la plaque (19) de support des contacts (4) de puce sous la forme de billes de brasure, de bosses de brasure et/ou de contacts (15) de tête au moyen de brasures (30), après une orientation de la puce (3) à semiconducteur.

8. Procédé suivant l'une des revendications 1 à 7, **caractérisé en ce que**
pour la fabrication d'une plaque (10) de matière plastique, on introduit la plaque (19) de support ayant des puces (3) à semiconducteur immobilisées dans un moule de moulage par injection et on remplit le moule de moulage par injection d'une masse de matière plastique avec incorporation des puces (3) à semiconducteur.

9. Procédé suivant l'une des revendications 1 à 7, **caractérisé en ce que**
pour fabriquer une plaque (10) en matière plastique, on recouvre la plaque (19) de support ayant des puces (3) à semiconducteur immobilisées d'un granulé de matière plastique et on échauffe la plaque (19) de support en faisant fondre le granulé, une plaque de forme parallèle au plan de la plaque (19) de support étant déposée sur la masse de matière plastique fondue.

10. Procédé suivant l'une des revendications 1 à 7, **caractérisé en ce que**
pour fabriquer une plaque (10) de matière plastique, on recouvre la plaque (19) de support ayant des puces (3) à semiconducteur immobilisées de matière plastique répandue avec incorporation des puces (3) à semiconducteur.

11. Procédé suivant l'une des revendications 1 à 10, **caractérisé en ce que**
on effectue la structuration du métal de la plaque (19) de support sur la plaque (10) de matière plastique en une structure (6) de recâblage ayant des faces (5) de bornes de contact, sur lesquelles les contacts (4) de puce sont immobilisés et/ou ayant des lignes (12) de recâblage et/ou des contacts (13) traversants, par attaques en voie humide du métal après orientation et dépôt d'un masque d'attaque.

12. Procédé suivant l'une des revendications 1 à 11, **caractérisé en ce que**
avant la structuration de la couche (3) métallique de la plaque (19) de support, on éloigne la plaque de base de la couche (3) métallique.

13. Procédé suivant l'une des revendications 1 à 12, **caractérisé en ce que**
on dispose d'autres structures (6) de recâblage sur la plaque (10) en matière plastique en mettant en alternance des couches isolantes ayant des contacts (13) traversants et des couches isolantes ayant des lignes (12) de recâblage sur la au moins une structure (6) de recâblage.

14. Procédé suivant l'une des revendications 1 à 13, **caractérisé en ce que**
on dépose des contacts (21) extérieurs sur une structure (6, 16, 17) extérieure de recâblage de l'ancillaire (2).

15. Procédé de fabrication d'un composant (1) électronique dans une position (9) de composant d'un ancillaire (2), comprenant les stades : fabrication d'un ancillaire suivant l'une des revendications 1 à 14 de procédé et séparation de l'ancillaire (2) le long des limites (22) de chacune des positions (9) de composant de l'ancillaire (2).
